(19) **Europäisches Patentamt**

**European Patent Office**

**Office européen des brevets**

(11) **EP 1 191 551 B1**

(12) **EUROPEAN PATENT SPECIFICATION**

(45) Date of publication and mention
of the grant of the patent:
**23.11.2005 Bulletin 2005/47**

(51) Int Cl.[7]: **H05K 1/16**, H01C 17/07,
H01C 17/28

(21) Application number: **01122336.9**

(22) Date of filing: **19.09.2001**

(54) **Resistor component with multiple layers of resistive material**

Widerstandselement aus mehreren resistiven Schichten

Composant résistif à couches multiples en matériau résistif

(84) Designated Contracting States:
**AT BE CH CY DE DK ES FI FR GB GR IE IT LI LU
MC NL PT SE TR**

(30) Priority: **22.09.2000 US 667294
02.08.2001 US 921074**

(43) Date of publication of application:
**27.03.2002 Bulletin 2002/13**

(73) Proprietor: **Nikko Materials USA, Inc.
Chandler, Arizona 85224 (US)**

(72) Inventors:
• **Wang, Jiangtao
Cleveland Heights, Ohio 44095-4001 (US)**
• **Centanni, Michael A.
Parma, Ohio 44130 (US)**
• **Clouser, Sidney J.
Chardon, Ohio 44024 (US)**

(74) Representative: **Becker, Thomas et al
Patentanwälte
Dr. Becker & Dr. Müller, Berkenbrink,
Turmstrasse 22
40878 Ratingen (DE)**

(56) References cited:
**EP-A- 0 452 812        EP-A- 0 540 820
US-A- 2 662 957        US-A- 4 503 112
US-A- 5 689 227**

**Description**

Field of the Invention

The present invention relates to multi-layer printed circuit boards and, more particularly, to a resistive component usable in forming boards with embedded resistive layers.

Background of the Invention

A basic component of a printed circuit board is a dielectric layer having a sheet of copper foil bonded thereto. Through a subtractive process that includes one or more etching steps, portions of the copper foil are etched away to leave a distinct pattern of conductive lines and formed elements on the surface of the dielectric layer. Multi-layer printed circuit boards are formed by stacking and joining two or more of the aforementioned dielectric layers having printed circuits thereon. Many printed circuit boards include conductive layers containing patterned components that perform like specific, discreet components. One such discreet component is a resistive element formed from a resistor foil. A resistor foil is basically a copper foil having a thin layer of resistive material, typically a metal or metal alloy deposited onto one surface thereof. The resistor foil is attached to a dielectric substrate with the resistive material adhered to the dielectric substrate. Using conventionally known masking and etching techniques, the copper foil and resistive material are etched away to produce a trace line of copper with the resistive material therebelow on the surface of the dielectric. A section of the copper layer is removed leaving only the resistive material on the surface connecting the two separated ends of the copper. Because the material forming the resistive layer typically has a conductivity less than copper, it essentially acts as a resistor between the separated ends of the copper trace lines. The thickness and width of the resistive layer, as well as the length of the resistive layer disposed between the ends of the copper traces, affect the resistance of the resistive element so formed.

US-A-2,662,957 discloses a resistance material for use in printed circuit products, comprising a copper layer, a first resistance material and a second resistance material.

The present invention represents an improvement over resistor foils known heretofore and provides a resistor foil having multiple layers of resistive material on a copper layer, thereby facilitating the formation of a variety of different resistive elements having a variety of resistance values.

Summary of the Invention

In accordance with a preferred embodiment of the present invention, there is provided a resistor foil, comprised of a copper layer having a first side and a second side. An intermediate layer in the form of an oxide layer having a thickness of between 5 Å and 70 Å is provided on the first side of the copper layer. A first layer of a first resistive material having a thickness of between 50 Å and 2 μm is on the intermediate layer, and a second layer of a second resistive material having a thickness of between 50 Å and 2 μm is on the first layer of the first resistive material. The first resistive material has a resistance different from the second resistive material. At least one of said first layer of said first resistive material and said second layer of said second resistive material includes materials according to claim 1. The oxide layer is comprised of an oxide of a metal according to claim 1.

A method of forming a resistive element on a printed circuit board can comprise the Steps of:

  a) adhering a resistor foil to a dielectric Substrate, the resistor foil comprised of:

    a copper layer having a first side and a second side;
    an intermediate layer having a thickness of between 5 Å and 70 Å on the first side of the copper layer;
    a first layer of a first resistor metal on the intermediate layer; and
    a second layer of a second resistor metal on the first layer of the first resistor metal, the first resistor metal having a resistance different from the second resistor metal, the resistor foil adhered to the substrate with the second layer of the second resistor metal facing the dielectric Substrate;

  b) forming a circuit trace line on the dielectric substrate from the resistor foil; and
  c) removing a portion of the copper layer and the intermediate layer from the circuit trace line to define a section of the circuit trace line comprised of the first and second layer of resistor metals.

These and other objects will become apparent from the following description of a preferred embodiment taken together with the accompanying drawings and the appended claims.

Brief Description of the Drawings

The invention may take physical form in certain parts and arrangement of parts, a preferred embodiment of which will be described in detail in the specification and illustrated in the accompanying drawings which form a part hereof, and wherein:

  FIG. 1 is an enlarged, cross-sectional view of a resistor foil (no embodiment of the present invention);
  FIG. 2 is an enlarged, cross-sectional view of a resistor foil illustrating an embodiment of the present invention;

FIG. 3 is a cross-sectional view showing the resistor foils shown in FIG. 2 attached to a dielectric substrate;

FIG. 4 is a perspective view of a resistive element formed from a resistor foil shown in FIG. 2;

FIG. 4A is a schematic, electrical representation of the resistive element shown in FIG. 4;

FIG. 5 is a partially sectioned, side elevational view of another resistive element shown in FIG. 2;

FIG. 5A is a schematic, electrical representation of the resistive element shown in FIG. 5;

FIG. 6 is a partially sectioned, side elevational view of a still further type of resistive element formed using the resistor foil shown in FIG. 2;

FIG. 6A is a schematic, electrical representation of the resistive element shown in FIG. 6;

FIG. 7 is a cross-sectional view of a resistive element formed from a resistor foil having three layers of resistive material thereon, not an embodiment of the present invention;

FIG. 7A is a schematic, electrical representation of the resistive element shown in FIG. 7; and

FIG. 8 is a perspective view of a resistive element formed from the resistor foil shown in FIG. 2, illustrating another embodiment of the present invention.

Detailed Description of Preferred Embodiment

The present invention relates to a resistor foil for use in forming embedded resistive elements in printed circuit boards. Broadly stated, the resistor foil is formed of a resistive copper foil having two or more layers of resistive material applied thereto. The resistive materials are preferably formed of metal. As used herein, the term "metal" refers to metals and alloys capable of vacuum deposition by the methods discussed herein.

The copper foils used with this invention can be made using one of two techniques. Wrought or rolled copper foil is produced by mechanically reducing the thickness of a copper or copper alloy strip or ingot by a process such as rolling. Electrodeposited foil is produced by electrolytically depositing from solution copper ions on a rotating cathode drum and then peeling the deposited foil from the cathode. Electrodeposited copper foils find advantageous application with this invention.

The copper foils typically have nominal thicknesses ranging from about 5.08µm to about 508 µm (about 0.0002 inch to about 0.02 inch). Copper foil thickness is sometimes expressed in terms of weight and typically the foils of the present invention have weights or thicknesses ranging from about 0.03814 kg/m² to about 4.273 kg/m² (about 1/8 to about 14 ounces per square foot (oz/ft²)). Especially useful copper foils are those having weights of 0.1017 kg/m², 0.1526 kg/m², 0.3052 kg/m² or 0.6104 kg/m² (1/3, 1/2, 1 or 2 oz/ft²).

Electrodeposited copper foils have a smooth or shiny (drum) side and a rough or matte (copper deposit growth front) side. The side or sides of the foil, to which the layer applied by the inventive process overlies, can be a "standard-profile surface," low-profile surface" or "very-low-profile surface." Useful embodiments involve the use of foils with low-profile surfaces and very low-profile surfaces. The term "standard-profile surface" is used herein to refer to a foil surface having a $R_{tm}$ (IPC- MF-150F) of greater than 10.2µ. The term "low-profile surface" refers to a foil surface having a $R_{tm}$ (IPC-MF-150F) of less than 10.2µ. The term "very-low-profile surface" refers to a foil surface having a $R_{tm}$ (IPC-MF-150F) of less than 5.1µ. $R_{tm}$ (IPC-MF-150F) is the mean of the maximum peak-to-valley vertical measurements from each of five consecutive sampling measurements, and can be measured using a SURTRONIC® 3 profilometer marketed by Rank Taylor Hobson, Ltd., Leicester, England.

The present invention finds advantageous application with copper foils of the type heretofore described.

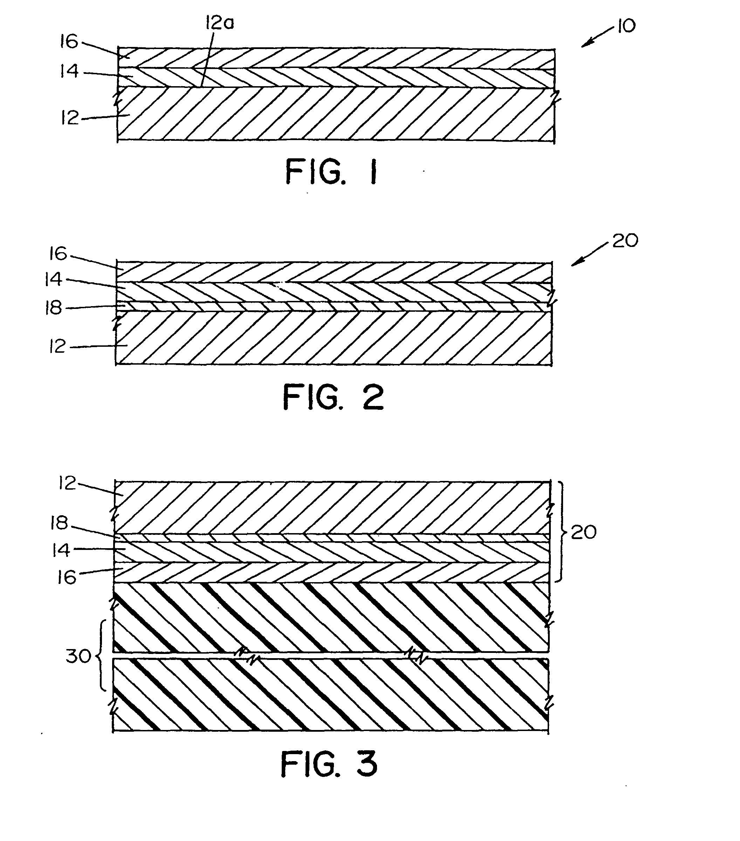

Referring now to FIG. 1, a resistor foil 10 is shown in cross-section. Resistor foil 10 is comprised of a copper layer 12. A first layer 14 of a first resistive material is applied to one side of copper layer 12. Layer 14 is preferably formed of a metal or metal alloy that is deposited onto copper layer 12 by a deposition process such as vacuum metalization, electrodeposition, electroless deposition or combinations thereof. Layer 14 is preferably applied to side 12a of copper layer 12 by an electrodeposition process or vacuum metalization. Layer 14 is formed of a metal having a resistivity greater than copper. Metals such as aluminum, zinc, nickel, nickel/chromium, nickel/chromium/aluminum/silicon alloy, titanium, vanadium, chromium, tantalum, iron, manganese and alloys, oxides, nitrides and silicides thereof, as well as any vapor depositable metal or alloy, oxide, nitride and silicide whose electrical resistivity is greater than that of copper, find advantageous application in forming layer 14. In a preferred embodiment, layer 14 is formed of a nickel/chromium/aluminum/silicon alloy. As layer 14 will ultimately be used to form a resistive element, the thickness of layer 14 will be based upon the resistivity of the metal forming layer 14 as well as the desired resistance of the resistive element to be formed. In this respect, layer 14 may have a thickness of between 50 Å to 2 µm. Layer 14 preferably has a thickness between 100 Å and 500 Å, and more preferably between 100 Å and 350 Å.

A second layer 16 of a second resistive material is applied onto layer 14. Layer 16 is preferably formed of a material different from that forming layer 14. The material forming layer 16 preferably has a resistivity different from the material forming layer 14, wherein layer 16 has a resistance different from layer 14.

Layer 16 may be formed from any of the same materials identified above i.e., aluminum, zinc, nickel, nickel/chromium, nickel/chromium/aluminum/silicon alloy, titanium, vanadium, chromium, tantalum, iron, manganese and alloys, oxides, nitrides and silicides thereof, as well as any vapor depositable metal or alloy, oxide, nitride and silicide whose electrical resistivity is greater than that of copper, subject to layer 16 having a resistance different from layer 14. Preferably second layer 16 is formed of compounds of tantalum and oxygen, e.g., $Ta_2O_5$, compounds of tantalum and nitrogen, e.g., $Ta_2N$ and $TaN_2$, or compounds of chromium and Silicon, e.g., CrSi.

Layer 16 is preferably applied by a deposition process such as vacuum metalization, electrodeposition, electroless deposition or combinations thereof. Layer 16 is preferably applied to layer 14 by an electrodeposition process or vacuum metalization.

As with layer 14, the thickness of layer 16 will be based upon the desired resistance of layer 16 and the resistance element to be formed, as well as on the material forming layer 16. In this respect, layer 16 may have a thickness of between 50 Å to 2 μm. Layer 16 preferably has a thickness between 100 Å and 500 Å, and more preferably between 100 Å and 350 Å.

Referring now to FIG. 2, a resistor foil 20, illustrating an embodiment of the present invention is shown. Resistor foil 20 is similar to resistor foil 10, and like elements are designated with like reference numbers. Resistor foil 20 differs from resistor foil 10 in that an intermediate layer, designated 18, is disposed between copper layer 12 and first layer 14. In this respect, it is conventionally known in the art to apply a "stabilizer" layer and/or a "tiecoat" layer to copper foils. Tiecoat layers are typically comprised of metals, such as by way of example and not limitation, zinc, nickel, palladium, titanium, tantalum, aluminum, iron, vanadium, chromium, chromium-based alloys, nickel-based alloys, and combinations thereof. Stabilizer layers are typically oxides, such as by way of example and not limitation, oxides of zinc, nickel, palladium, titanium, tantalum, aluminum, iron, vanadium, chromium, chromium-based alloys, nickel-based alloys, and combinations thereof. As used herein, the term "intermediate layer 18" shall refer to an oxide layer, comprised of an oxide of a metal as in claim 1, disposed on copper layer 12.

Intermediate layer 18 is applied to a clean surface of the copper. Intermediate layer 18, whether a stabilizer layer or a tiecoat layer, may be applied by a vacuum deposition process such as sputtering, e-beam deposition or thermal evaporation, or by electrodeposition or dipping or spraying. Intermediate layer 18 has a thickness between 5 Å and 70 Å, and more preferably, between about 10 Å and about 20 Å. In a preferred embodiment, intermediate layer 18 is a stabilizer comprised of chromium oxide.

Referring now to the use of resistor foil 10 or resistor foil 20 in forming a resistive element, FIG. 3 shows resistor foil 20 adhered to a dielectric substrate 30. As will be appreciated from a further reading of the specification, the following discussion would also apply if resistor foil 10 is used. Resistor foil 20 may be secured to dielectric substrate 30 using an adhesive (not shown), or adhered to dielectric substrate 30 by a lamination process, wherein dielectric substrate 30 is cured with resistor foil 20 attached thereto. Methods of securing a resistor foil, such as foils 10 and 20 are conventionally known, and the particular method used in and of itself is not critical to the present invention.

Resistor foil 20 is attached to dielectric substrate 30 with second layer 16 closest to, and facing, substrate 30 (as shown in FIG. 3), and with copper layer 12 exposed. Using conventionally known processes of masking and etching, unwanted areas of resistor foil 20 are etched away to leave a circuit pattern (not shown) on the surface of dielectric substrate 30.

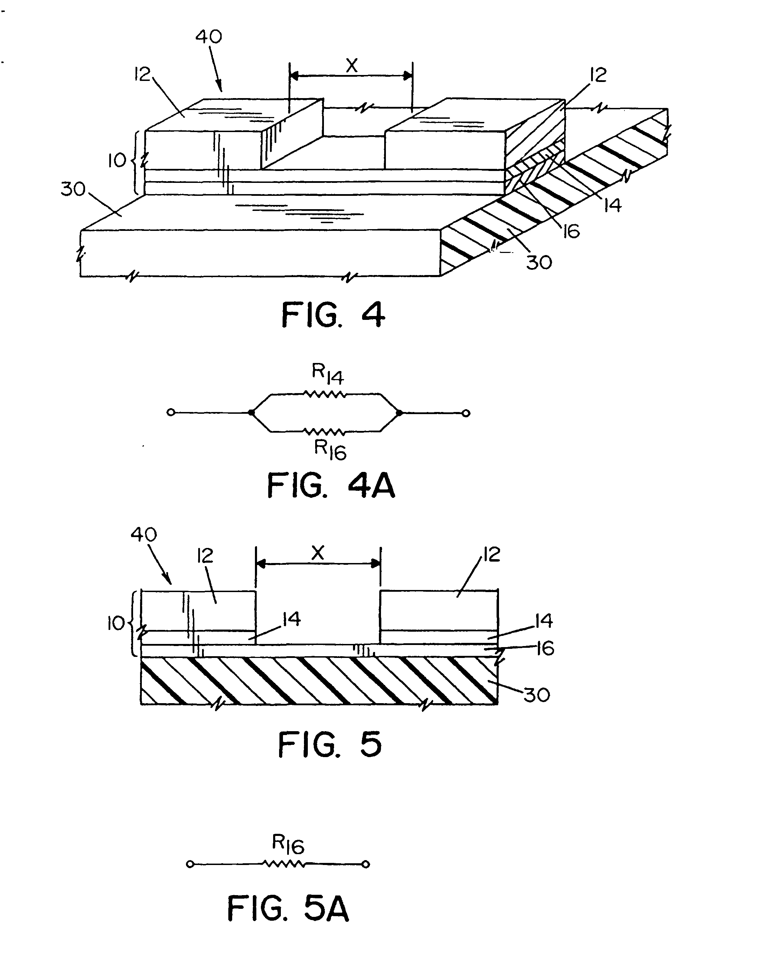

FIG. 4 is a perspective view of a portion of a circuit showing a trace line 40 on substrate 30. A section, designated "X," of copper layer 12 is removed from trace line 40, by conventionally known masking and etching techniques, to leave only first and second layers 14, 16 of first and second resistor materials connecting the spaced-apart ends of copper layer 12. In other words, section X essentially forms a resistive element between the spaced-apart ends of copper layer 12 of trace line 40. Any current flow through trace line 40 must necessarily flow through first and second layers 14, 16 of section X. Since first layer 14 has a different resistance than second layer 16, the total resistance of section X is a function of both layers 14, 16.

FIG. 4A is an electrical, schematic representation of the resistance of section X. The resistive element shown in FIG. 4 is the equivalent of two resistors $R_{14}$, $R_{16}$ in parallel, where $R_{14}$ is the resistance of first layer 14 in section X and $R_{16}$ is the resistance of second layer 16 in section X. The total resistance, $R_{TOTAL}$, of the resistive element shown in FIG. 4 is determined by the following equation:

$$R_{TOTAL} = \frac{(R_{14})\,(R_{16})}{R_{14} + R_{16}}$$

FIG. 5 shows a variation to trace element 40, as shown in FIG. 4, that produces a different resistive element. In the embodiment shown in FIG. 5, first layer 14 is also etched away in section X (by conventional masking and etching techniques), leaving only second layer 16 in section X. The resistance of the element shown in FIG. 5 is a function of resistance $R_{16}$ of second layer 16 in section X. The resulting resistive element is equivalent to that schematically illustrated in FIG. 5A. FIGS. 4-5A thus show how two different resistive elements may be formed from the same resistor foil 10 by merely changing the number of layers removed, i.e., etched away, from trace line 40.

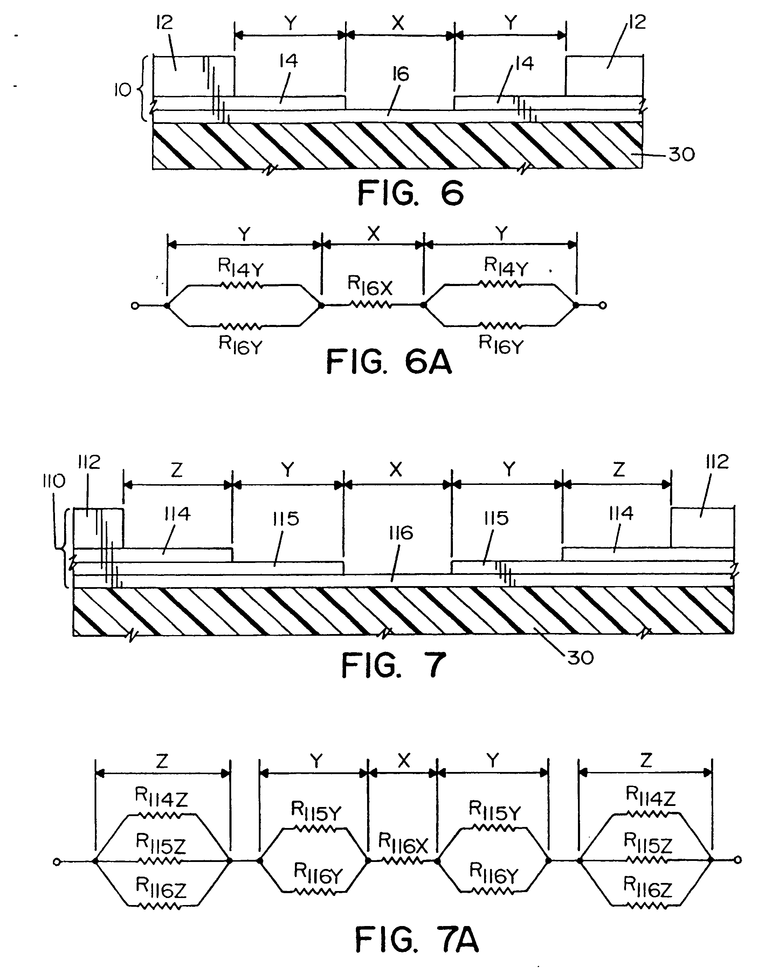

FIGS. 6 and 6A show still another embodiment of a resistive element that may be formed from resistor foil 10. In the embodiment shown in FIG. 6, resistor foil 10 has been masked and etched to form a trace line (shown in cross-section in FIG. 6) and the trace line masked and etched to form a resistive element having a central section "X" and two sections "Y" adjacent thereto. In section X, only second layer 16 remains. In sections Y, both first and second layers 14 and 16 remain.

The resistance of the resultant structure is shown in FIG. 6A, wherein the resistance of sections Y are equivalent to two resistors $R_{14Y}$ and $R_{16Y}$ in parallel, wherein $R_{14Y}$ is the resistance of first layer 14 in section Y and $R_{16Y}$ is the resistance of second layer 16 in section Y. The resistance of section X is $R_{16X}$ which is the resistance of second layer 16 in section X. The total resistance of the structure shown in FIGS. 6 and 6A is the sum of the resistances of each section.

The resistive elements heretofore described were formed with a resistor foil 10 having two layers of resistive materials thereon, i.e., first layer 14 and second layer 16. FIG. 7 shows a cross-sectional view of a resistive element formed from a resistor foil 110 having three layers of resistor material thereon. Resistor foil 110 has a copper layer 112, a first layer 114 of a first resistive material, a second layer 115 of a second resistive material and a third layer 116 of a third resistive material. Each resistive material has a different resistivity such that each layer 114, 115 and 116 has a different resistance value. Resistor foil 110 is masked and etched to produce a central zone "X" comprised of layer 116, intermediate sections "Y" comprised of layers 115 and 116 and outer sections "Z" comprised of layers 114, 115 and 116. As shown in FIG. 7A, and like the structures previously discussed, the resistance of the structure shown in FIG. 7 is the sum of resistance of each of sections X, Y and Z, and the resistance of sections Y and Z are determined by the respective resistances of layers 114, 115 and 116 in parallel. FIG. 7 thus illustrates that a resistor foil having more than two resistive layers may be formed and a variety of different resistor values can be created.

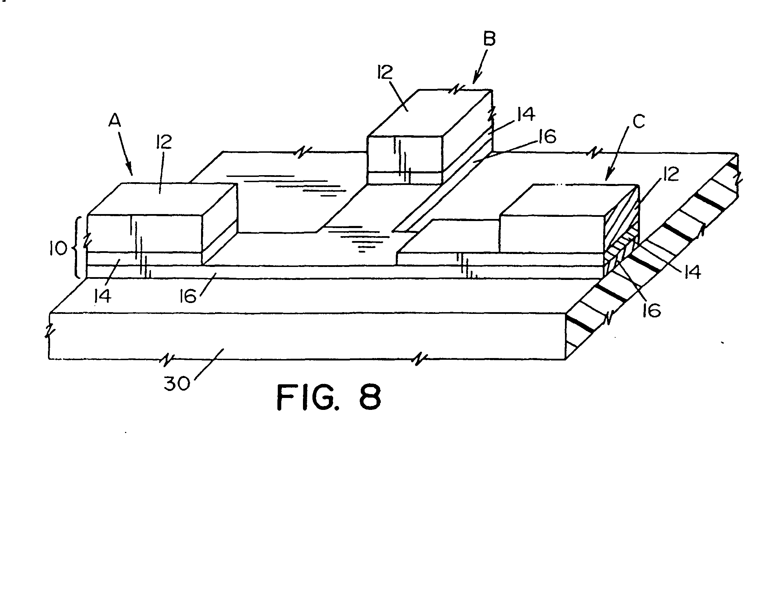

Heretofore, single trace lines having resistive elements formed therein have been described. FIG. 8 illustrates how a circuit having a junction of three branches, designated A, B and C, can be formed from resistor foil 10. FIG. 8 illustrates how multiple branch lines trace lines having one or more branches with different resistances may be formed.

The foregoing description discloses specific embodiments of the present invention. These embodiments are described for purposes of illustration only.

## Claims

1. A resistor foil for use in forming an embedded resistor in a printed circuit board comprised of:

a copper layer (12) having a first side and a second side;
an oxide layer (18) having a thickness of between 5 Å and 70 Å on said first side of said copper layer;
a first layer (14) of a first resistive material having a thickness of between 50 Å and 2 μm on said oxide layer (18); and
a second layer (16) of a second resistive material having a thickness of between 50 Å and 2 μm on said first layer (14) of said first resistive material,

wherein at least one of said first layer (14) of said first resistive material and said second layer (16) of said second resistive material includes a material selected from the group consisting of aluminum, zinc, nickel, nickel/chromium, nickel/chromium/aluminum/silicon alloy, titanium, vanadium, chromium, tantalum, iron, manganese and alloys, oxides, nitrides and silicides thereof, said first resistive material having a resistance different from said second resistive material,

and wherein said oxide layer (18) is comprised of an oxide of a metal selected from the group consisting of zinc, nickel, palladium, titanium, tantalum, aluminum, iron, vanadium, chromium, chromium-based alloys and nickel-based alloys, and combinations thereof.

2. A resistor foil as defined in claim 1, wherein said first resistive material is different from said second resistive material.

3. A resistor foil as defined in claim 2, wherein said first resistive material is nickel/chromium/aluminum/silicon alloy.

4. A resistor foil as defined in claim 3, wherein said second resistive material is tantalum oxide.

## Patentansprüche

1. Widerstandsfolie zur Verwendung bei der Ausbildung eines in einer Leiterplatte eingebetteten Widerstands, umfassend:

eine Kupferschicht (12) mit einer ersten und einer zweiten Seite;

eine auf der ersten Seite der Kupferschicht aufgebrachte Oxidschicht (18) mit einer Dicke von zwischen 5 Å und 70 Å;

eine auf der Oxidschicht (18) aufgebrachte erste Schicht (14) eines ersten Widerstandsmaterials mit einer Dicke von zwischen 50 Å und 2 µm und

eine auf der ersten Schicht (14) des ersten Widerstandsmaterials aufgebrachte zweite Schicht (16) eines zweiten Widerstandsmaterials mit einer Dikke von zwischen 50 Å und 2 µm,

wobei wenigstens eine der ersten Schicht (14) des ersten Widerstandsmaterials und der zweiten Schicht (16) des zweiten Widerstandsmaterials ein Material umfasst, ausgewählt aus der Gruppe bestehend aus Aluminium, Zink, Nickel, Nickel-Chrom, einer Nickel-Chrom-Aluminium-Silizium-Legierung, Titan, Vanadium, Chrom, Tantal, Eisen, Mangan und deren Legierungen, Oxide, Nitride und Silicide, wobei das erste Widerstandsmaterial einen vom Widerstand des zweiten Widerstandsmaterials abweichenden Widerstand hat, und dass die Oxidschicht (18) ein Oxid eines Metalls umfasst, ausgewählt aus der Gruppe bestehend aus Zink, Nickel, Palladium, Titan, Tantal, Aluminium, Eisen, Vanadium, Chrom, chrombasierte Legierungen und nickelbasierte Legierungen und deren Kombinationen.

**2.** Widerstandsfolie nach Anspruch 1, **dadurch gekennzeichnet, dass** das erste Widerstandsmaterial und das zweite Widerstandsmaterial unterschiedlich sind.

**3.** Widerstandsfolie nach Anspruch 2, **dadurch gekennzeichnet, dass** das erste Widerstandsmaterial eine Nickel-Chrom-Aluminium-Silizium-Legierung ist.

**4.** Widerstandsfolie nach Anspruch 3, **dadurch gekennzeichnet, dass** das zweite Widerstandsmaterial Tantaloxid ist.

**Revendications**

**1.** Film de résistances destiné à être utilisé pour former une résistance intégrée dans une plaquette de circuit imprimé, du type comportant :

une couche de cuivre (12) avec une première et une deuxième face ;

une couche d'oxyde (18) d'une épaisseur comprise entre 5 Å et 70 Å sur la première face de la couche de cuivre ;

une première couche (14) d'un premier matériau résistif d'une épaisseur comprise entre 50 Å et 2 µm sur la couche d'oxyde (18) ; et

une deuxième couche (16) d'un deuxième matériau résistif d'une épaisseur comprise entre 50 Å et 2 µm sur la première couche (14) du premier matériau résistif,

où au moins une de la première couche (14) du premier matériau résistif ou de la deuxième couche (16) du deuxième matériau résistif comprend un matériau choisi parmi l'aluminium, le zinc, le nickel, un alliage nickel-chrome, un alliage nickel-chrome-aluminium-silicium, le titan, le vanadium, le chrome, le tantale, le fer, le manganèse et leurs alliages, oxydes, nitrures et siliciures, le premier matériau résistif ayant une résistance différente de celle du deuxième matériau résistif,

et où la couche d'oxyde (18) comporte l'oxyde d'un métal choisi parmi le zinc, le nickel, le palladium, le titan, le tantale, l'aluminium, le fer, le vanadium, le chrome, les alliages à base de chrome et

les alliages à base de nickel ainsi que leurs combinaisons.

**2.** Film de résistances selon la revendication 1, **caractérisé en ce que** le premier matériau résistif est différent du deuxième matériau résistif.

**3.** Film de résistances selon la revendication 2, **caractérisé en ce que** le premier matériau résistif est un alliage de nickel-chrome-aluminium-silicium.

**4.** Film de résistances selon la revendication 3, **caractérisé en ce que** le deuxième matériau résistif est de l'oxyde de tantale.

FIG. 1

FIG. 2

FIG. 3

EP 1 191 551 B1

FIG. 4

$R_{14}$

$R_{16}$

FIG. 4A

FIG. 5

$R_{16}$

FIG. 5A

8

FIG. 6

FIG. 6A

FIG. 7

FIG. 7A

FIG. 8